Europäisches Patentamt

European Patent Office

Office européen des brevets

(19)

(11) Veröffentlichungsnummer: **0 316 534 B1**

(12) **EUROPÄISCHE PATENTSCHRIFT**

(45) Veröffentlichungstag der Patentschrift: **27.11.91**

(51) Int. Cl.⁵: **G01F 23/72**, H01H 36/02

(21) Anmeldenummer: **88115053.6**

(22) Anmeldetag: **15.09.88**

(54) **Schaltungselement.**

(30) Priorität: **19.11.87 DE 8715341 U**

(43) Veröffentlichungstag der Anmeldung:
**24.05.89 Patentblatt 89/21**

(45) Bekanntmachung des Hinweises auf die
Patenterteilung:
**27.11.91 Patentblatt 91/48**

(84) Benannte Vertragsstaaten:
**AT DE FR GB IT SE**

(56) Entgegenhaltungen:
**DE-U- 8 705 400**
**GB-A- 2 023 347**
**US-A- 4 537 070**

(73) Patentinhaber: **Kübler, Wolfgang
An der Loretohöhe 11
CH-6300 Zug(CH)**

(72) Erfinder: **Kübler, Wolfgang
An der Loretohöhe 11
CH-6300 Zug(CH)**

(74) Vertreter: **Hach, Hans Karl, Dr.
Tarunstrasse 23
W-6950 Mosbach-Waldstadt(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung betrifft ein Schaltungselement zur Bestückung eines flexiblen, langgestreckten, bandförmigen Isolierträgers für den Meßleiter eines Niveaumeßwertgebers, mit einem quaderförmigen, langgestreckten Kunststoffgehäuse aus elektrisch isolierendem Material, mit einem langgestreckten elektrischen Schalter, der magnetisch betätigbar ist und dessen Kontakte in einem mit Schutzgas gefüllten, geschlossenen Röhrchen stecken, mit einem langgestreckten elektrischen Widerstand, bei dem Schalter und Widerstand achsparallel zu ihrer Längsachse und zur Längsachse des Kunststoffgehäuses nebeneinander innerhalb des Kunststoffgehäuses angeordnet sind, und mit je zwei metallenen Anschlußstiften für den Schalter und den Widerstand, die aus einer gemeinsamen Längsseite des Kunststoffgehäuses herausragen und sich mit ihren Enden parallel zueinander und senkrecht zu dieser Längsseite erstrecken.

Bei einem aus dem DE-GM 8705400 vorbekannten Schaltungselement dieser Art sind die Anschlußstifte die Enden von Anschlußdrähten, die von beiden Enden des Schalters beziehunsweise Widerstandes ausgehen und entsprechend abgebogen sind. Das setzt den Einsatz von Widerständen und Schaltern voraus, die mit entsprechend starken Anschlußdrähten ausgestattet sind.

Da die Anschlußstifte nicht nur zum elektrischen Anschluß des Schaltungselementes, sondern auch zu desssen Halterung dienen, sind solide und stabile Anschlußstifte wünschenswert. Aus diesem Grunde ist es Aufgabe der Erfindung, ein Schaltungselement der eingangs genannten Art auf möglichst einfache Weise mit stabilen Anschlußstiften auszugestalten.

Die Erfindung löst diese Aufgabe dadurch, daß die Anschlußstifte Teile von Anschlußzungen sind, die bis an das Ende des jeweils zugehörigen Schalters oder Widerstandes reichen, daß die Anschlußzungen aus einer gemeinsamen Blechplatte ausgestanzte, flache Streifen sind, daß die den Anschlußstiften abgekehrten freien Enden der Anschlußzungen den Anschlußenden des zugehörigen Schalters oder Widerstandes durch Abbiegen geometrisch angeformt sind und daß die Anschlußzungen im übrigen durchgehend gleichstarke flache Streifen sind, die in einer gemeinsamen Ebene liegen.

Aus der GB-PS 20 32 347 ist ein Schaltungselement bekannt, bei dem einige Merkmale dieser Lösung verwirklicht sind. Es sind aber bei dieser Vorveröffentlichung die Anschlußstifte nicht durch Abbiegen geometrisch den Anschlußenden angeformt und die Anschlußzungen liegen auch nicht in einer gemeinsamen Ebene. In einer gemeinsamen Ebene liegen sie zwar bei einer Ausführungsform aus der zuerst genannten Vorveröffentlichung, aber bei dieser Ausführungsform handelt es sich um Anschlußzungen in Form von Drähten und nicht in Form von flachen Streifen und im Zusammenhang mit flachen Streifen hat die Lage in einer gemeinsamen Ebene eine andere Bedeutung als im Zusammenhang mit Drähten.

Bei der Massenproduktion wird der Widerstand und der Schalter zunächst an den freien Enden der Anschlußzungen positioniert. Dabei ist es wünschenswert, diese Teile zu fixieren, bis sie elektrisch, zum Beispiel durch Löten oder Schweißen, mit den Anschlußzungen verbunden sind und dadurch auch mechanisch befestigt werden. Das wird gelöst durch die erwähnte geometrische Anformung.

Durch diese geometrische Anformung kann man leicht eine Auflage für den Schalter und den Widerstand finden, in die sie unverrückbar eingepaßt werden können.

Das kann zum Beispiel für die Schalter in Form einer spitzwinkligen Kerbe geschehen und für die Widerstände dadurch, daß die freien Enden der innen gelegenen Anschlußzungen L-förmig ausgebildet sind, und zwar mit dem freien L-Steg nach außen ragend, und daß diese freien Stege nach oben rechtwinklig abgebogen sind.

Eine bevorzugte Ausgestaltung, die sich durch übersichtlichen Aufbau und dadurch bedingte einfache Massenproduktion auszeichnet, ist im Anspruch 2 gekennzeichnet.

Schaltungselemente nach der Erfindung lassen sich auch leicht herstellen. Ein bevorzugtes Herstellungsverfahren ist dadurch gekennzeichnet, daß aus einer Blechplatine die Anschlußzungen eines Schaltungselementes ausgestanzt werden, wobei ein Querstreifen des Blechmaterials stehenbleibt, der die vier Anschlußstifte miteinander und mit der Platine verbindet, daß dann die den Anschlußstiften abgekehrten Enden der Anschlußzungen durch Biegen dem Schalter und dem Widerstand angeformt werden, daß dann der Schalter und Widerstand eingesetzt, geometrisch an den Anschlußzungen fixiert und elektrisch mit den Anschlußzungen verbunden wird, daß dann die Anschlußzungen, mit dem Widerstand und dem Schalter, unter Freilassen der Anschlußstifte und der Querverbindung mit dem Kunststoff des Kunststoffgehäuses umgossen werden und daß dann die Querverbindung ausgestanzt wird.

Für die Massenproduktion empfiehlt es sich, daß die Blechplatine Teil eines langen Blechstreifens ist, auf dem aneinandergereiht Schaltungselemente hergestellt werden.

Die Erfindung wird nun anhand der beigefügten Zeichnung näher erläutert.

In der Zeichnung zeigt:

Figur 1    den Abschnitt eines mit Schaltungselementen nach der Erfindung ausgestatteten Meßleiters, teilweise im
Schnitt,

Figur 2 den Schnitt II aus Figur 1,
Figur 3 den Isolierträger aus Figur 1 von
der dem Beschauer von Figur 1
abgekehrten Seite gesehen,
Figur 4 ein elektrisches Ersatzschaltbild zu
Figur 1,

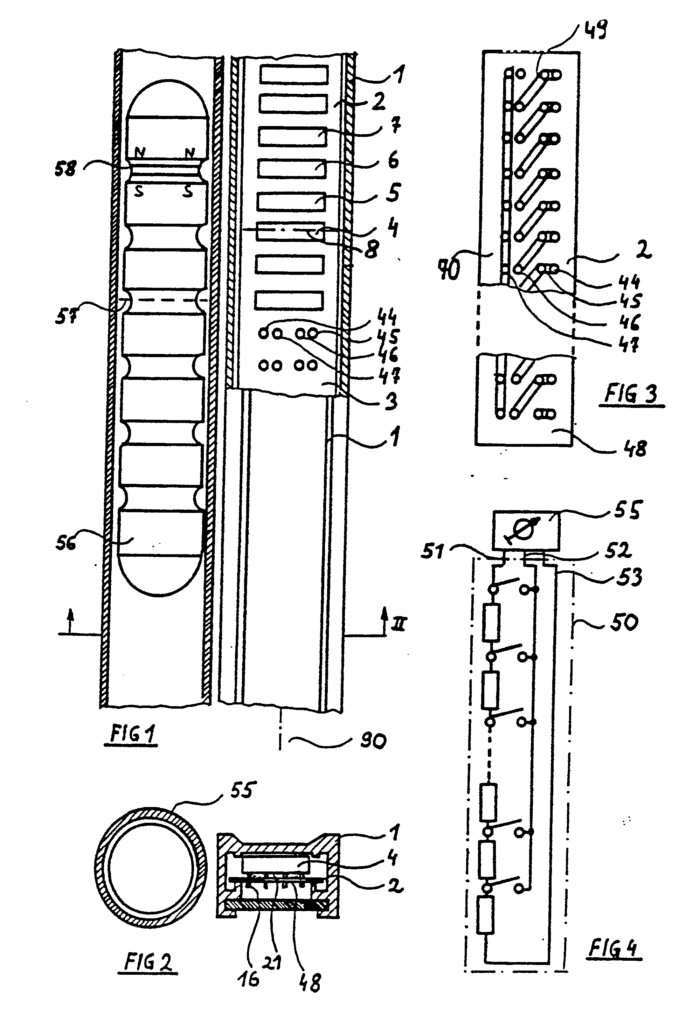

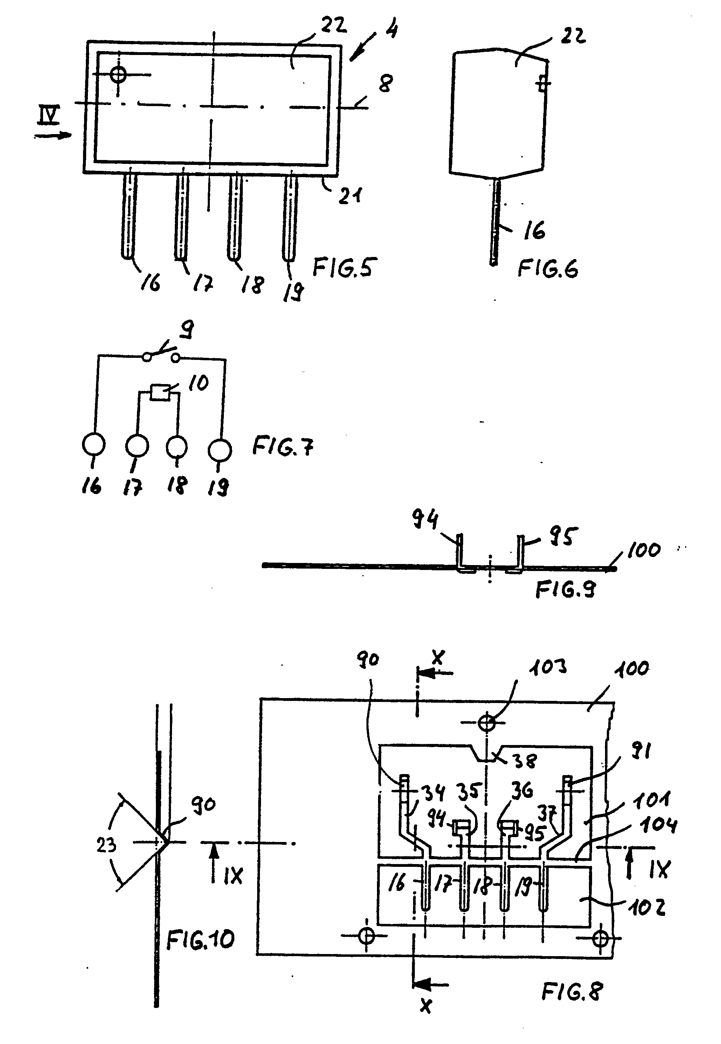

Figur 5 ein Schaltungselement aus Figur 1
in der Ansicht entsprechend Figur
2,
Figur 6 die Ansicht gemäß dem Pfeil VI aus
Figur 5,
Figur 7 das Ersatzschaltbild zu Figur 5,
Figur 8 eine ausgestanzte Platine zur Herstellung eines Schaltungselementes
nach Figur 5,
Figur 9 den Teilschnitt IX aus Figur 8,
Figur 10 den Schnitt X aus Figur 8,
Figur 11 die Platine aus Figur 8 mit eingesetztem Schaltungselement und
eingesetztem Widerstand,
Figur 12 eine Platine mit dem angegossenen
Gehäuse,
Figur 13 eine gegenüber Figur 1 und 2 abgeänderte Ausgestaltung eines mit
Schaltungselementen bestückten
Isolierträgers, und

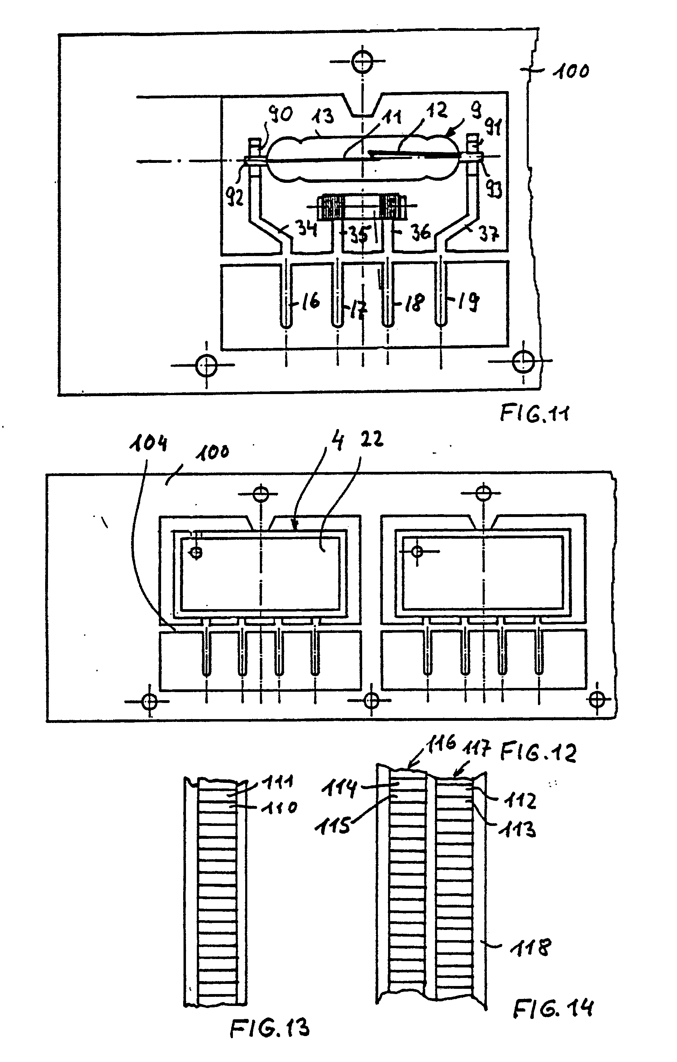

Figur 14 eine weitere abgeänderte Ausgestaltung eines Isolierträgers.

In der Zeichnung ist mit 1 ein aus Aluminium
bestehendes Tragrohr bezeichnet, das im Querschnitt die Form eines langgestreckten Rechtecks
hat. In dem Tragrohr 1 steckt ein langgestreckter,
bandförmiger, flexibler Isolierträger 2, auf dessen
Tragseite 3 quaderförmige, langgestreckte,
gleichgroße Schaltungselemente 4 bis 7 dicht aneinander aufgereiht sind. Das Schaltungselement 4
ist in Figur 5 und 6 dargestellt und hat die Form
eines langgestreckten Quaders, dessen Längsachse mit 8 bezeichnet ist.

Innerhalb des Schaltungselementes ist ein
langgestreckter Schalter 9 und ein langgestreckter
Widerstand 10 untergebracht. Der Schalter 9 und
der Widerstand 10 sind in Kunststoff eingegossen.
Durch den Kunststoff wird das Kunststoffgehäuse
22 gebildet. Der Schalter 9 ist magnetisch betätigbar, seine Kontakte 11 und 12 sind in einem geschlossenen, mit Schutzgas gefüllten Röhrchen 13
untergebracht. Die Längsachse 14 des Schalters ist
achsparallel zur Längsachse 15 des Widerstandes
und zur Längsachse 8 des Schaltungselementes 4.

Mit 16, 17, 18 und 19 sind Anschlußstifte bezeichnet, die aus dem Kunststoffgehäuse 22 herausragen. Diese Anschlußstifte 16 bis 19 sind, wie
aus Figur 6 ersichtlich, entlang einer geraden Linie
aufgereiht und durchsetzen die Gehäusewandung des Kunststoffgehäuses 22 an der einen Längsseite, der sogenannten Anschlußseite 21 und erstrek-
ken sich senkrecht zur Anschlußseite. Die Anschlußseite 21 ist diejenige Längsseite des Kunststoffgehäuses, die in montiertem Zustand dem Isolierträger 2 zugekehrt ist, also in Figur 1 dem
Beschauer abgekehrt ist.

Die Anschlußstifte 16 bis 19 stecken in Löchern des Isolierträgers 2, zum Beispiel den Löchern 44, 45, 46, 47. Um diese Löcher zu zeigen,
sind in Figur 1 einige Schaltungselemente nicht mit
eingezeichnet.

Die Anschlußstifte 16 bis 19 sind jeweils Teile
von Anschlußzungen 34, 35, 36, 37, die sich zum
Teil innerhalb des Kunststoffgehäuses 22 erstrek-
ken. Die Anschlußzungen sind sämtlichst in einer
gemeinsamen Ebene, nämlich der Zeichenebene
von Figur 11 angeordnet. In dieser Ebene erstrek-
ken sich auch der Schalter 9 und der Widerstand
10. Der Widerstand 10 ist langgestreckt und wesentlich kürzer als der ebenfalls langgestreckte
Schalter 9. Die beiden mittleren Anschlußzungen
35, 36 erstrecken sich geradlinig bis an die Enden
des Widerstandes. Die beiden außen gelegenen
Anschlußzungen dagegen sind im Inneren des
Kunststoffgehäuses 22 gegenüber den zugehörigen Anschlußstiften 16, 19 auf einen der Länge des
Schalters 9 entsprechenden größeren Abstand abgewinkelt.

Die freien enden der äußeren Anschlußzungen
sind zu einer spitzwinkligen Kerbe 90 beziehungsweise 91 gebogen. Der entsprechende Winkel 23
beträgt 90° (Grad). In diese Kerben passen die bis
auf kurze Stummel 92, 93 abgeschnittenen Anschlußdrähte der Schalters. Die freien Enden der
innen gelegenen Anschlußzungen 35, 36 sind L-
förmig ausgestanzt, und zwar mit dem freien L-
Steg nach außen ragend. Diese freien L-Stege 94,
95 sind nach oben rechtwinklig abgebogen. Die so
geformten freien Enden der Anschlußzungen 35, 36
bilden eine Aufnahme für den Widerstand 10.

Wie aus Figur 3 ersichtlich, ist auf der Rückseite des Isolierträgers 2, der sogenannten Verbindungsseite 48, ein Leitungsbild 49 aufgetragen,
durch eine Beschichtung aus elektrisch leitendem
Metall. Die Löcher, zum Beispiel die Löcher 44 bis
47, sind von der Beschichtung des Leitungsbildes
49 eng umgeben. Die durch die Löcher hindurchgesteckten Enden der Anschlußstifte sind mit dem
Leitungsbild beziehungsweise der Beschichtung
verlötet. Die Beschichtung des Leitungsbildes 49
ist elektrisch leitend und unmittelbar angrenzend an
die Löcher 44 bis 47 festhaftend auf dem Isolierträger 2 vorgesehen.

Die Schaltungselemente sind mit ihrer Längsachse quer zur Längsachse des Isolierträgers 2
dicht nebeneinander einzeln aufgereiht. Die Schaltungselemente 4 bis 7 sind etwa so lang wie der Isolierträger 2 breit ist, so daß noch minimaler erforderlicher Isolierabstand 70, 71 zum Rand stehenbleibt, im übrigen aber durch den Isolierträger 2 kein unnötiger Platz benötigt wird, so daß die ganze Anordnung, wie aus Figur 2 ersichtlich, mitsamt dem den bestückten Isolierträger eng umgebenden Tragrohr 1 möglichst gedrängt gebaut ist und wenig Platz im Querschnitt einnimmt.

Es ergibt sich das in Figur 4 dargestellte Ersatzschaltbild, bei dem die Widerstände aller Schaltungselemente in Reihe geschaltet sind und diese Reihenanordnung durch die zugeordneten Schalter stufenweise abgegriffen ist. Der Widerstandswert zwischen den Ausgangsleitungen 51, 52, 53 des in Figur 4 durch die strichpunktierte Linie 50 umgrenzten Isolierträgers 2 ändert sich, je nachdeem welcher der Schalter geschlossen ist.

Achsparallel neben dem Tragrohr 1 ist ein Führungsrohr 55 angeordnet, das aus magnetisch inaktivem Material besteht und innerhalb dessen ein Schwimmer 56 gleiten kann. Das Rohr 55 kommuniziert mit einem äußeren Flüssigkeitsstand, so daß sich innerhalb des Rohrs 55 ein Flüssigkeitsniveau 57 einstellt, das sich ständig verändert und den Schwimmer 56 anhebt und absenkt - bei aufrechter Anordnung des Tragrohrs 1 und des Führungsrohrs 55.

Innerhalb des Schwimmers 56 ist ein Permanentmagnet 58 angeordnet, der einen oder zwei auf gleicher Höhe befindliche Schalter schließt. Durch diesen Schalterschluß werden die Widerstandswerte zwischen den Ausgangsleitungen 51 bis 53 nach Maßgabe der Höhenlage des Schwimmers und damit nach Maßgabe der Höhenlage des Flüssigkeitsniveaus 57 verändert und in einem Füllstands-Anzeigegerät zur Anzeige gebracht.

Zur Herstellung der Schaltungselemente geht man von einer Blechplatine 100 aus, die aus weichlötbarem Material bestehen kann, also beispielsweise Kupfer, oder mit einem weichlötbaren Überzug versehen ist, zum Beispiel Stahlblech mit einer Zinnbeschichtung. Auch eine Blechplatine 100 aus Stahl oder Weicheisen ist geeignet. Dann erfolgt die elektrische Verbindung durch Schweißen oder Hartlöten.

Die Blechplatine 100 ist ein langgestreckter Streifen. In Figur 8 ist nur das eine Ende abgebrochen dargestellt, in Figur 10 ist ein etwas längeres Stück dargestellt. Aus der Platine werden für jedes Schaltungselement zwei Ausstanzungen 101, 102 vorgenommen nebst einigen Positionierungslöchern 103. Innerhalb der Ausstanzungen bleiben die Anschlußzungen 34, 35, 36, 37 stehen und außerdem wird ein Querstreifen 104 stehengelassen, der die Anschlußzungen mit der Platine 100 verbindet, sowie eine Haltenase 38. Die den Anschlußstiften abgekehrten Enden werden nun zu den Kerben 90, 91 gebogen und es werden die L-Stege 94, 95 umgebogen. Dann werden wie in Figur 11 dargestellt der Schalter 9 und der Widerstand 10 eingesetzt und an ihren Kontaktenden mit den Anschlußenden verlötet oder verschweißt und dabei auch gleichzeitig befestigt.

Dann werden die Anschlußzungen mit dem Widerstand und dem Schalter, aber unter Freilassen der Anschlußstifte 16 bis 19, des Querstreifens 104 und der Spitze der Haltenase 38 mit dem Kunststoff des Kunststoffgehäuses 22 umgossen, wie aus Figur 12 ersichtlich. Dann wird der Querstreifen 104 ausgestanzt, die Spitze der Haltenase 38 abgestanzt und das Schaltungselement 4 ist fertig.

Die Blechplatine 100 ist ein langer Blechstreifen, auf dem aufeinandergereiht Schaltungselemente, wie soeben für das Schaltungselement 4 beschrieben, hergestellt werden.

Die Schaltungselemente werden dann wie im Text zu Figur 1 und 3 beschrieben eingesetzt und verlötet.

Für eine feine Anzeige ist es wichtig, daß die Schaltungselemente möglichst dicht beieinander liegen. Nach Figur 1 sind Lücken ausgespart, man kann also die Schaltungselemente nach Figur 1 noch dichter zusammenrücken, lückenlos wie nach Figur 13 für die Schaltungselemente 110, 111 geschehen. Man kann, wenn man eine noch feinere Anzeige wünscht, auch mehrere Reihen von Schaltungselementen nebeneinander auf Lücke anordnen, wie dies in Figur 14 für die Schaltungselemente 112, 113, 114, 115 dargestellt ist, die in zwei Reihen 116, 117 auf Lücke nebeneinander auf einem gemeinsamen Isolierträger 118 angeordnet sind.

Die Isolierträger sind aus flexiblem Material. Der bestückte Isolierträger kann um einen Radius von etwa 50 cm (Zentimeter) von der dem Beschauer von Figur 1 abgekehrten Seite, also zu der Seite, an der sich nicht die Schaltungselemente befinden, gebogen werden. Zur gegenüberliegenden Seite kann der bestückte Isolierträger gebogen werden um einen Radius, dessen Größe abhängig ist von der Größe der Lücken zwischen den einzelnen Schaltungselementen.

**Patentansprüche**

1.  Schaltungselement zur Bestückung eines flexiblen, langgestreckten, bandförmigen Isolierträgers für den Meßleiter eines Niveaumeßwertgebers,

    mit einem quaderförmigen, langgestreckten Kunststoffgehäuse aus elektrisch isolierendem Material,

    mit einem langgestreckten elektrischen Schalter, der magnetisch betätigbar ist und dessen Kontakte in einem mit Schutzgas gefüllten, geschlossenen Röhrchen stecken,

mit einem langgestreckten elektrischen Widerstand,

bei dem Schalter und Widerstand achsparallel zu ihrer Längsachse und zur Längsachse des Kunststoffgehäuses nebeneinander innerhalb des Kunststoffgehäuses angeordnet sind, und

mit je zwei metallenen Anschlußstiften für den Schalter und den Widerstand, die aus einer gemeinsamen Längsseite des Kunststoffgehäuses herausragen und sich mit ihren Enden parallel zueinander und senkrecht zu dieser Längsseite erstrecken, dadurch gekennzeichnet,

daß die Anschlußstifte (16 - 19) Teile von Anschlußzungen (34 - 37) sind, die bis an das Ende des jeweils zugehörigen Schalters ( 9 ) oder Widerstandes ( 10 ) reichen,

daß die Anschlußzungen aus einer gemeinsamen Blechplatte ( 100 ) ausgestanzte, flache Streifen sind,

daß die den Anschlußstiften (16 - 19) abgekehrten freien Enden der Anschlußzungen (34 - 37) den Anschlußenden des zugehörigen Schalters ( 9 ) oder Widerstandes ( 10 ) durch Abbiegen geometrisch angeformt sind und

daß die Anschlußzungen im übrigen durchgehend gleichstarke flache Streifen sind, die in einer gemeinsamen Ebene liegen.

2. Schaltungselement nach Anspruch 1, dadurch gekennzeichnet,

daß der Widerstand ( 10 ) ein langgestrecktes Element ist, das wesentlich kürzer als der Schalter ( 9 ) ist,

daß Schalter und Widerstand in der durch die Anschlußzungen (34 - 37) definierten Ebene angeordnet sind, und zwar der Schalter auf der den Anschlußstiften (16 - 19) abgekehrten Seite des Widerstandes,

daß die beiden mittleren Anschlußzungen (35, 36) bis zu den angeformten Enden geradlinig sind und dem Widerstand zugeordnet sind und

daß die beiden außen gelegenen Anschlußzungen (34, 37) im Inneren des Kunststoffgehäuses ( 22 ) gegenüber den zugehörigen Anschlußstiften (16, 19) auf einen der Länge des Schalters entsprechenden, größeren Abstand abgewinkelt sind.

3. Schaltungselement nach einem der vorhergehenden Ansprüche, dadurch gekennzeichnet,

daß die den Anschlußstiften ( 16, 19) abgekehrten freien Enden der äußeren Anschlußzungen (34, 37) zu einer spitzwinkligen Kerbe (90 ) gebogen sind.

4. Schaltungselement nach einem der vorhergehenden Ansprüche, dadurch gekennzeichnet,

daß die den Anschlußstiften ( 17, 18) abgekehrten freien Enden der innen gelegenen Anschlußzungen (35, 36) L-förmig ausgebildet sind, und zwar mit dem freien L-Steg nach außen ragend, und

daß diese freien L-Stege (94, 95) nach oben rechtwinklig abgebogen sind.

## Claims

1. Circuit element for equipping a flexible, elongated, strip-like insulating support for the test conoductor of a level transducer, with a parallelepipedic, elongated plastic casing made from electrically insulating material, with an elongated electric switch, which is magnetically operable and whose contacts are engaged in a closed tube filled with inert gas, with an elongated electrical resistor, in which the switch and the resistor are juxtaposed within the plastic casing in axially parallel manner to their longitudinal axis and to the longitudinal axis of the plastic casing, with in each case two metallic connecting pins for the switch and the resistor, which project out of a common longitudinal side of the plastic casing and extend with their ends parallel to one another and perpendicular to said longitudinal side, characterized in that the connecting pins (16 to 19) are parts of connecting tongues (34 to 37), which extend up to the end of the associated switch (9) or the resistor (10), that the connecting tongues are flat strips punched from a common sheet metal plate (100), that the free ends of the connecting tongues (34 to 37) remote from the connecting pins (16 to 19) are geometrically shaped by bending onto the connecting ends of the associated switch (9) or resistor (10) and that the connecting tongues are otherwise equally thick, flat strips, which are located in a common plane.

2. Circuit element according to claim 1, characterized in that the resistor (10) is an elongated element, which is much shorter than the switch (9), that the switch and the resistor are located in a plane defined by the connecting tongues (34 to 37) and the switch is located on the side of the resistor remote from the connecting pins (16 to 19), that the two central connecting tongues (35, 36) are linear up to the shaped on ends and are associated with the resistor and that the two outer connecting tongues (34, 37) in the interior of the plastic casing (22) with respect to the associated connecting pins (16, 19) are bent to a larger spacing corresponding to the switch length.

3. Circuit element according to one of the preceding claims, characterized in that the free ends of the outer connecting tongues (34, 37) remote from the connecting pins (16, 19) are bent to an acute-angled notch (90).

4. Circuit element according to one of the preceding claims, characterized in that the free ends of the inner connecting tongues (35, 36) remote from the connecting pins (17, 18) are given a L-shaped construction with the free L-leg pointing outwards and that these free L-legs (94, 95) are bent upwards at right angles.

**Revendications**

1. Elément de circuit pour l'équipement d'un support isolant en forme de bande, oblong et flexible, pour le conducteur de mesure d'un transmetteur de valeur de mesure de niveau, avec un boîtier en plastique parallélépipèdique et oblong, en matériau électriquement isolant, avec un commutateur électrique oblong, qui peut être actionné magnétiquement et dont les contacts sont enfichés dans un tube capillaire fermé, rempli de gaz protecteur, avec une résistance électrique oblongue, dans lequel le commutateur et la résistance sont disposés l'un à côté de l'autre à l'intérieur du boîtier en plastique, avec des axes longitudinaux parallèles entre eux et à l'axe longitudinal du boîtier, et avec deux broches de raccordement métallisées respectives pour le commutateur et pour la résistance, qui sortent d'un même côté longitudinal du boîtier en plastique et dont les extrémités s'étendent parallèlement entre elles et perpendiculairement à ce côté longitudinal, caractérisé en ce que les broches de raccordement (16-19) font partie de languettes de raccordement (34-37) qui s'étendent jusqu'à l'extrémité du commutateur (9) ou de la résistance (10) qui leur est respectivement associé(e), en ce que les languettes de raccordement sont des bandes plates découpées à partir d'une plaque de tôle commune (100), en ce que les extrémités libres des languettes de raccordement (34-37) qui sont opposées aux broches de raccordement (16-19) sont façonnées géométriquement, par pliage, aux extrémités de raccordement du commutateur (9) ou de la résistance (10) associée, et en ce que les languettes de raccordement sont au reste des bandes plates d'épaisseur toujours identique, qui se situent dans un même plan.

2. Elément de circuit selon la revendication 1, caractérisé en ce que la résistance (10) est un élément oblong qui est nettement plus court que le commutateur (9), en ce que le commutateur et la résistance sont disposées dans un plan défini par les languettes de raccordement (34-37), le commutateur se trouvant sur le côté de la résistance qui est opposé aux broches de raccordement (16-19), en ce que les deux languettes de raccordement médianes (35, 36) sont rectilignes jusqu'aux extrémités façonnées, et associées à la résistance, et en ce que les deux languettes de raccordement en position extérieure (34, 37) partent, à l'intérieur du boîtier en plastique (22), en coude par rapport aux broches de raccordement associées (16, 19) sur une distance supérieure, correspondant à la longueur du commutateur.

3. Elément de circuit selon l'une des revendications précédentes, caractérisé en ce que les extrémités libres, opposées aux broches de raccordement (16, 19), des languettes de raccordement extérieures (34, 37) sont recourbées en une encoche à angle aigu (90).

4. Elément de circuit selon l'une des revendications précédentes, caractérisé en ce que les extrémités libres, opposées aux broches de raccordement (17, 18), des languettes de raccordement en position intérieure (35, 36) sont configurées en L, la branche libre du L dépassant vers l'extérieur, et en ce que ces branches libres de L (94, 95) sont recourbées à angle droit vers le haut.

FIG 1

FIG 2

FIG 3

FIG 4

FIG.5

FIG.6

FIG.7

FIG.9

FIG.10

FIG.8

FIG.11

FIG.12

FIG.13

FIG.14